# EUROPEAN PATENT APPLICATION

(11) **EP 4 841 180 A1**
(43) Date of publication of application: **18.11.2026**
(21) Application number: 26151517.5
(22) Date of filing: 13.01.2026
(51) Int. Cl.: F25B 25/00, F25B 41/20, F25B 49/02, H05K 7/20

(54) **COOLING SYSTEM**

(30) Priority: 16.05.2025 US 202563807529 P; 02.01.2026 US 202619439257
(71) Applicant: Vertiv Corporation, Westerville, OH 43082 (US)
(72) Inventor: GERIG, Galen Lewis, Westerville, 43082 (US); PAUL, Romeo, Westerville, 43082 (US)
(74) Representative: Kilburn & Strode LLP

(57) **Abstract**

A cooling system can include a heat exchanger, a first sensor for sensing an exit temperature of a cooling fluid exiting the heat exchanger, a second sensor for sensing a supply temperature of the cooling fluid entering a load, and a diverter valve for selectively bypassing the heat exchanger. The cooling system can selectively heat the cooling fluid from the exit temperature to a supply temperature setpoint when the exit temperature is below the supply temperature setpoint, and can supply the first cooling fluid to the load at the supply temperature setpoint.

## Description

### CROSS-REFERENCE TO RELATED APPLICATION(S)

This application claims the benefit of priority of U.S. Provisional Patent Application No. 63/807,529 filed May 16, 2025 and U.S. Non-Provisional Patent Application No. 19/439,257 filed January 2, 2026.

### TECHNICAL FIELD

The present disclosure relates generally to cooling systems for data centers and more specifically relates to managing high fluid temperatures in such cooling systems.

### BACKGROUND

Cooling systems, such as those used in data centers, often utilize a two-phase refrigerant as a cooling fluid in one or more cooling loops and a compressor to compress refrigerant that has been evaporated in the extraction of heat. The cooling of higher fluid temperatures can increase the suction pressure and temperature at the compressor. With lower outdoor ambient temperatures, the condensing pressure can also drop, and the increased suction pressure and the lower condensing pressure can converge, thus lowering differential pressure across the compressor to a point outside the operating envelope of the compressor. This can shorten the lifespan of the compressor.

### SUMMARY

Applicant has created new and useful devices, systems and methods for managing higher fluid temperatures in cooling systems, such as those used in data centers. High fluid temperatures can cause high compressor suction pressures. This, especially combined with low ambient conditions and resulting low condensing pressures, can cause a compressor to operate with differential pressures outside of its ideal operating parameters. In at least one embodiment, a cooling system according to the disclosure can maintain sufficiently high differential pressure across the compressor, such as by loading the compressor and over-cooling the fluid. In at least one embodiment, a cooling system according to the disclosure can avoid providing over-cooled fluid to a load, such as by diverting a portion of the fluid and heating the fluid upstream of the load.

In at least one embodiment, a cooling system according to the disclosure can include a first cooling loop, a second cooling loop, and a controller. In at least one embodiment, the first cooling loop can include a load, a first cooling fluid for extracting heat from the load, a heat exchanger for extracting heat from the first cooling fluid, a pump for circulating the first cooling fluid through the load and the heat exchanger, a first sensor for sensing an exit temperature of the first cooling fluid exiting the heat exchanger, a second sensor for sensing a supply temperature of the first cooling fluid entering the load downstream of the heat exchanger, a diverter valve for selectively diverting a portion of the first cooling fluid from upstream of the heat exchanger to a blending point in the first cooling loop between the first sensor and the second sensor, bypassing the heat exchanger, or any combination thereof.

In at least one embodiment, the heat exchanger can transfer heat from the first cooling fluid to a second cooling fluid circulating in the second cooling loop. In at least one embodiment, the second cooling loop can include a compressor for selectively compressing an evaporated portion of the second cooling fluid and/or inducing the second cooling fluid to flow through the second cooling loop, a condenser for rejecting heat from the second cooling fluid, an economizer pump for selectively pumping the second cooling fluid through the second cooling loop, or any combination thereof.

In at least one embodiment, the controller can monitor various sensors and/or control various components of the system. In at least one embodiment, the controller can monitor the exit temperature, the supply temperature, one or more ambient conditions, such as one or more other temperatures, one or more pressures, one or more temperatures and/or pressures associated with the condenser and/or the compressor, such as a condensing pressure, a condensing temperature, a suction pressure of the compressor, an outlet pressure of the compressor, a differential pressure across the compressor, one or more other conditions, or any combination thereof. In at least one embodiment, the controller can control the diverter valve, the compressor, the pump, an expansion valve, one or more other valves and/or one or more fans of the system, other components associated with the system, or any combination thereof.

In at least one embodiment, the controller can ensure and/or seek to ensure that the first cooling fluid enters the load at or reasonably near the supply temperature setpoint, the compressor operates within its operating parameters when it is needed to cool the first cooling fluid, shut down the compressor and run the economizer pump when the compressor is not needed to cool the first cooling fluid, or any combination thereof. In at least one embodiment, the controller can selectively heat the first cooling fluid from the exit temperature to a supply temperature setpoint, such that the first cooling fluid enters the load at the supply temperature setpoint, when the exit temperature is below the supply temperature setpoint. In at least one embodiment, the controller can selectively heat the first cooling fluid by operation of the diverter valve, diverting a portion of the first cooling fluid to the blending point and bypassing the heat exchanger. In at least one embodiment, the controller can determine an opening position for the diverter valve, based at least in part on the exit temperature, the supply temperature, an operating condition of the compressor, an ambient condition, such as an ambient temperature, one or more other temperatures and/or pressures, or any combination thereof, such as for selectively heating the first cooling fluid from the exit temperature to the supply temperature setpoint.

In at least one embodiment, the controller can control the exit temperature of the first cooling fluid exiting the heat exchanger, such as by controlling operation of the economizer pump, the compressor, one or more other components of the system, or any combination thereof. In at least one embodiment, the controller can cool the first cooling fluid exiting the heat exchanger, such as when a condition is below a threshold and/or the compressor is running. In at least one embodiment, the controller can cool the first cooling fluid exiting the heat exchanger below the supply temperature setpoint and simultaneously heat the first cooling fluid from the exit temperature to the supply temperature setpoint before entering the load, such as to ensure the first cooling fluid enters the load at the supply temperature setpoint and the compressor is operating within parameters. In at least one embodiment, the controller can prevent any portion of the first cooling fluid from bypassing the heat exchanger utilizing the diverter valve, such as when the compressor is not running, when the economizer pump is running, when cooling the first cooling fluid is near the supply temperature setpoint, or any combination thereof.

In at least one embodiment, the controller can monitor one or more conditions associated with the second loop, such as one or more temperatures, one or more pressures, one or more differential pressures, or any combination thereof. In at least one embodiment, the controller can cause the compressor to cool the first cooling fluid exiting the heat exchanger below the supply temperature setpoint, such as when the compressor is running and/or when the condition is below a threshold. In at least one embodiment, the controller can selectively cause the compressor to cool the first cooling fluid exiting the heat exchanger below the supply temperature setpoint and simultaneously control the diverter valve to heat the first cooling fluid from the exit temperature to the supply temperature setpoint before entering the load.

In at least one embodiment, the controller can monitor a differential pressure across the compressor. In at least one embodiment, the controller can ensure the differential pressure stays within the operating parameters of the compressor and the first cooling fluid enters the load at the supply temperature setpoint. In at least one embodiment, the controller can maintain the differential pressure above a threshold by cooling the first cooling fluid exiting the heat exchanger below the supply temperature setpoint. In at least one embodiment, the controller can control the diverter valve to divert at least a portion of the first cooling fluid to the blending point, bypassing the heat exchanger, to heat the first cooling fluid to the supply temperature setpoint before entering the load. In at least one embodiment, the controller can maintain the differential pressure above a threshold by causing the compressor to cool the first cooling fluid exiting the heat exchanger below the supply temperature setpoint and simultaneously control the diverter valve to heat the first cooling fluid from the exit temperature to the supply temperature setpoint before entering the load.

### BRIEF DESCRIPTION OF THE DRAWINGS

FIG. 1 is a flow diagram of one of many embodiments of a cooling loop according to the disclosure.
FIG. 2 is a flow diagram of another one of many embodiments of a cooling loop according to the disclosure.
FIG. 3 is a simplified block diagram of one of many embodiments of a cooling loop according to the disclosure.
FIG. 4 is a time plot of compressor inlet and outlet pressures without a diverter valve according to the disclosure.
FIG. 5 is a time plot of compressor inlet and outlet pressures with a diverter valve according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various embodiments of the present disclosure. in this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicant has created new and useful devices, systems and methods for managing higher fluid temperatures in cooling systems, such as those used in data centers. High fluid temperatures can cause high compressor suction pressures. This, especially combined with low ambient conditions and resulting low condensing pressures, can cause a compressor to operate with differential pressures outside its ideal operating parameters. In at least one embodiment, a cooling system according to the disclosure can maintain sufficiently high differential pressure across the compressor, such as by loading the compressor and over-cooling the fluid. In at least one embodiment, a cooling system according to the disclosure can avoid providing over-cooled fluid to a load, such as by diverting a portion of the fluid and heating the fluid upstream of the load.

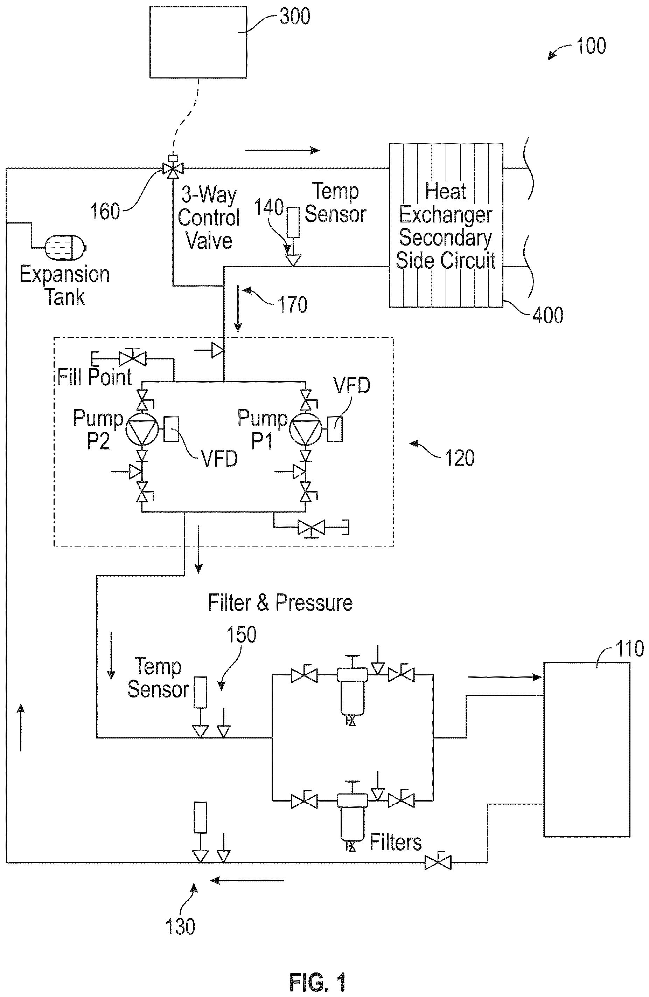

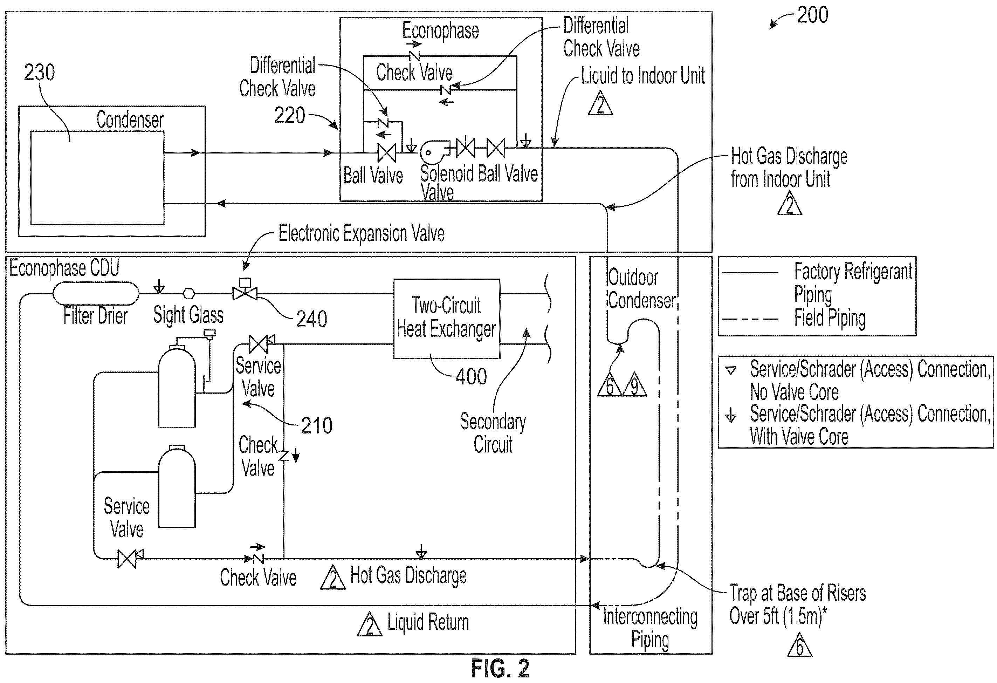

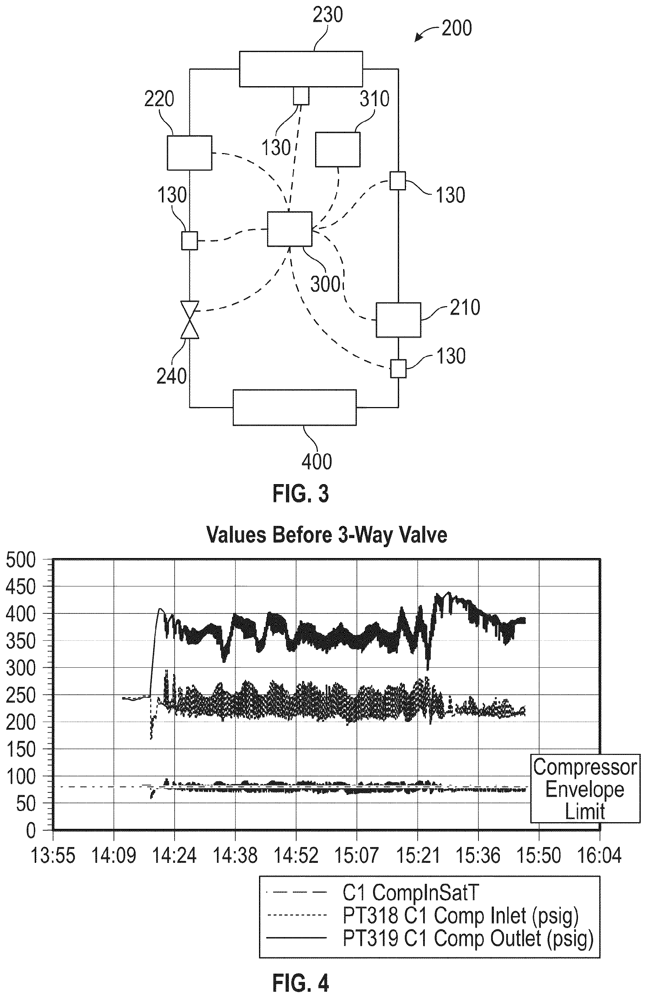

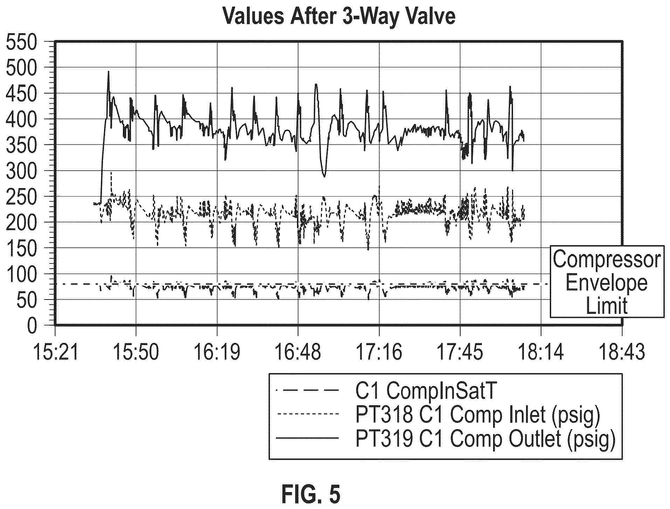

FIG. 1 is a flow diagram of one of many embodiments of cooling loop according to the disclosure. FIG. 2 is a flow diagram of another one of many embodiments of cooling loop according to the disclosure. FIG. 3 is a simplified block diagram of one of many embodiments of cooling loop according to the disclosure. FIG. 4 is a time plot of compressor inlet and outlet pressures without a diverter valve according to the disclosure. FIG. 5 is a time plot of compressor inlet and outlet pressures with a diverter valve according to the disclosure. FIGS. 1-5 are described in conjunction with one another.

In at least one embodiment, a cooling system according to the disclosure can include one or more cooling loops, such a first cooling loop 100 and/or a second cooling loop 200, one or more controllers 300, or any combination thereof. In at least one embodiment, the first cooling loop 100 can include one or more loads 110, one or more first cooling fluids for extracting heat from the load 110, one or more heat exchangers 400 for extracting heat from the first cooling fluid, one or more pumps 120 for circulating the first cooling fluid through the load 110 and the heat exchanger 400, one or more sensors 130, such as a first sensor 140 for sensing an exit temperature of the first cooling fluid exiting the heat exchanger 400 and/or a second sensor 150 for sensing a supply temperature of the first cooling fluid entering the load 110 downstream of the heat exchanger 400, one or more diverter valves 160 for selectively diverting a portion of the first cooling fluid from upstream of the heat exchanger 400 to one or more blending points 170 in the first cooling loop, such as between the first sensor 140 and the second sensor 150, bypassing the heat exchanger 400, or any combination thereof.

In at least one embodiment, the load 110 can be or include computer equipment, such as that found in a data center. In at least one embodiment, the load 110 can be or include direct-to-chip heat exchangers. In at least one embodiment, the pump 120 can be or include one or more pumps plumbed in parallel, such as to selectively allow high flow rates, low turn down flow rates, maintenance redundancy, or any combination thereof. In at least one embodiment, the sensors 130 can be or include one or more pressure sensors, one or more temperature sensors, one or more flow sensors, one or more humidity sensors, one or more other sensors, or any combination thereof. In at least one embodiment, the sensors 130 can be in or associated with the first loop 100, the second loop 200, the controller 300, the heat exchanger 400, or any combination thereof.

In at least one embodiment, the heat exchanger 400 can be or include a brazed plate heat exchanger (BPHE) and/or another type of heat exchanger. In at least one embodiment, the heat exchanger 400 can transfer heat from one cooling fluid to another cooling fluid and/or a gaseous cooling media, such as air. In at least one embodiment, any or all of the cooling fluids can be single-phase cooling fluids, such as water and/or a water/glycol mixture, two-phase fluids, such as one or more refrigerants, gaseous cooling media, or any combination thereof.

In at least one embodiment, the heat exchanger 400 can transfer heat from the first cooling fluid circulating in the first cooling loop 100 to a second cooling fluid circulating in the second cooling loop 200. In at least one embodiment, the second cooling loop 200 can include one or more compressors 210 for selectively compressing an evaporated portion of the second cooling fluid and/or inducing the second cooling fluid to flow through the second cooling loop 200, one or more economizer pumps 220 for selectively pumping the second cooling fluid through the second cooling loop 200, one or more condensers 230 for rejecting heat from the second cooling fluid, one or more expansion valves 240 for controlling heat extraction within the heat exchanger 400, or any combination thereof.

In at least one embodiment, the controller 300 can monitor various sensors 130 and/or control various components of the system. In at least one embodiment, the controller 300 can include one or more user interfaces 310, such as for providing a desired supply temperature setpoint. In at least one embodiment, the user interface 310 can be disposed locally to the controller 300, the first loop 100, the second loop 200, or any combination thereof. In at least one embodiment, the user interface 310 can be disposed remotely from the controller 300, the first loop 100, the second loop 200, or any combination thereof.

In at least one embodiment, the controller 300 can monitor the exit temperature, the supply temperature, one or more ambient conditions, such as pressure and/or temperature, one or more temperatures and/or pressures associated with the condenser 230 and/or the compressor 210, such as a condensing pressure, a condensing temperature, a suction pressure of the compressor 210, an outlet pressure of the compressor 210, a differential pressure across the compressor 210, one or more other conditions, or any combination thereof. In at least one embodiment, the controller 300 can control the pump 120, the diverter valve 160, the compressor 210, the economizer pump 220, the expansion valve 240, one or more other valves and/or one or more fans of the system, other components associated with the system, or any combination thereof.

In at least one embodiment, the controller 300 can ensure and/or seek to ensure that the first cooling fluid enters the load 110 at or reasonably near the supply temperature setpoint, the compressor 210 operates within its operating parameters when it is needed to cool the first cooling fluid, shut down the compressor 210 and run the economizer pump 220 when the compressor 210 is not needed to cool the first cooling fluid, or any combination thereof. In at least one embodiment, the controller 300 can selectively heat the first cooling fluid from the exit temperature to a supply temperature setpoint, such that the first cooling fluid enters the load 110 at the supply temperature setpoint, when the exit temperature is below the supply temperature setpoint. In at least one embodiment, the controller 300 can selectively heat the first cooling fluid by operation of the diverter valve 160, diverting a portion of the first cooling fluid to the blending point 170 and bypassing the heat exchanger 400. In at least one embodiment, the controller 300 can determine an opening position for the diverter valve 160, based at least in part on the exit temperature, the supply temperature, an operating condition of the compressor 210, an ambient condition, such as an ambient temperature, one or more other temperatures and/or pressures, or any combination thereof, such as for selectively heating the first cooling fluid from the exit temperature to the supply temperature setpoint.

In at least one embodiment, the controller 300 can control the exit temperature of the first cooling fluid exiting the heat exchanger 400, such as by controlling operation of the economizer pump 220, the compressor 210, one or more other components of the system, or any combination thereof. In at least one embodiment, the controller 300 can cool the first cooling fluid exiting the heat exchanger 400 when a condition is below a threshold and/or the compressor 210 is running. In at least one embodiment, the controller 300 can cool the first cooling fluid exiting the heat exchanger 400 below the supply temperature setpoint and simultaneously heat the first cooling fluid from the exit temperature to the supply temperature setpoint before entering the load 110, such as to ensure the first cooling fluid enters the load 110 at the supply temperature setpoint and/or the compressor 210 is operating within parameters. In at least one embodiment, the controller 300 can prevent any portion of the first cooling fluid from bypassing the heat exchanger 400, such as by controlling the diverter valve 160 so as to, such as when the compressor 210 is not running, when the economizer pump 220 is running, when the first cooling fluid is at, near, or above the supply temperature setpoint, or any combination thereof.

In at least one embodiment, the controller 300 can monitor one or more conditions associated with the second loop 200, such as one or more temperatures, one or more pressures, one or more differential pressures, or any combination thereof. In at least one embodiment, the controller 300 can monitor one or more ambient temperatures, one or more condensing pressures, one or more differential pressures, such as across the compressor 210, or any combination thereof. In at least one embodiment, the controller 300 can cause the compressor 210 to cool the first cooling fluid exiting the heat exchanger 400 below the supply temperature setpoint, such as when a condition is below a threshold (i.e. when the ambient temperature is low, when the condensing pressure is low, when the differential pressure across the compressor 210 is low, or any combination thereof). In at least one embodiment, the controller 300 can cause the compressor 210 to cool the first cooling fluid exiting the heat exchanger 400 below the supply temperature setpoint, such as when the compressor 210 is running and/or when the condition is below a threshold. In at least one embodiment, the controller 300 can selectively cause the compressor 210 to cool the first cooling fluid exiting the heat exchanger 400 below the supply temperature setpoint and simultaneously control the diverter valve 160 to heat the first cooling fluid from the exit temperature to the supply temperature setpoint before entering the load 110. In at least one embodiment, the controller 300 can open the diverter valve 160, allowing a portion of the first cooling fluid (at a high temperature) to bypass the heat exchanger 400 and mix with the first cooling fluid exiting the heat exchanger 400 (at a temperature below the supply temperature setpoint) at the blending point 170, and in doing so the controller 300 can heat the first cooling fluid from the exit temperature to the supply temperature setpoint before entering the load 110.

In at least one embodiment, the controller 300 can monitor a differential pressure across the compressor 210. In at least one embodiment, the controller 300 can ensure the differential pressure stays within the operating parameters of the compressor 210 and the first cooling fluid enters the load 110 at the supply temperature setpoint. In at least one embodiment, the controller 300 can maintain the differential pressure above a threshold by cooling the first cooling fluid exiting the heat exchanger 400 below the supply temperature setpoint. In at least one embodiment, the controller 300 can run the compressor 210 hard enough to ensure that the differential pressure across the compressor 210 stays within the operating parameters of the compressor 210, even though doing so may cool the first cooling fluid exiting the heat exchanger 400 below the supply temperature setpoint. In at least one embodiment, the controller 400 can control the diverter valve 160 to divert at least a portion of the first cooling fluid to the blending point 170, bypassing the heat exchanger 400, to heat the first cooling fluid to the supply temperature setpoint before entering the load 110. in at least one embodiment, the controller 300 can maintain the differential pressure above a threshold by causing the compressor 210 to cool the first cooling fluid exiting the heat exchanger 400 below the supply temperature setpoint and simultaneously control the diverter valve 160 to heat the first cooling fluid from the exit temperature to the supply temperature setpoint before entering the load 110.

As will be appreciated by those skilled in the art having the benefits of the present disclosure, aspects of one or more embodiments of the disclosure can be embodied as a system, method or computer program product. Accordingly, aspects of the present embodiments can take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present disclosure may take the form of a computer program product embodied in one or more non-transitory computer readable mediums having computer readable program code embodied thereon. Any combination of one or more computer readable media may be utilized. The computer readable media may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of such computer readable storage media include but are not limited to the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Program code embodied on a computer readable medium may be transmitted using any appropriate medium or media, including but not limited to wireless, wireline, optical fiber cable, radio frequency (RF), or any suitable combination of the foregoing. Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on a user's computer, partly on a user's computer, as a stand-alone software package, partly on a user's computer and partly on a remote computer, or entirely on a remote computer or server. In the latter scenario, the remote computer may be connected to a user's computer through any type of network, including a local area network (LAN) or a wide area network (WAN), or the connection may be made to an external computer (for example, through the Internet using an Internet Service Provider or via a short-range wireless interconnection such as Bluetooth).

Aspects of the present disclosure can be described with reference to flowchart illustrations and/or block diagrams of methods, apparatuses (devices and systems) and computer program products according to embodiments of the disclosure. Each block of a flowchart illustration and/or block diagram, and combinations of blocks in a flowchart illustration and/or block diagrams, can be implemented by computer program instructions. These computer program instructions may be provided to a processor of a general purpose computer, special purpose computer, or other programmable data processing apparatus to produce a machine, such that the instructions, which executed via one or more processors, create means for implementing the functions/acts specified in the flowchart and/or block diagram block or blocks. The computer program instructions can be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks. Each block in a flowchart and/or block diagram can be split into multiple blocks and/or combined with other blocks to make a single block.

In at least one embodiment, a cooling system according to the disclosure can include a first cooling loop, a second cooling loop, a controller, or any combination thereof. In at least one embodiment, the first cooling loop can include a load, a first cooling fluid for extracting heat from the load, a heat exchanger for extracting heat from the first cooling fluid, a pump for circulating the first cooling fluid through the load and the heat exchanger, a first sensor for sensing an exit temperature of the first cooling fluid exiting the heat exchanger, a second sensor for sensing a supply temperature of the first cooling fluid entering the load downstream of the heat exchanger, a diverter valve for selectively diverting a portion of the first cooling fluid from upstream of the heat exchanger to a blending point in the first cooling loop between the first sensor and the second sensor, bypassing the heat exchanger, or any combination thereof.

In at least one embodiment, the heat exchanger can transfer heat from the first cooling fluid to a second cooling fluid circulating in the second cooling loop. In at least one embodiment, the second cooling loop can include a compressor for selectively compressing an evaporated portion of the second cooling fluid and/or inducing the second cooling fluid to flow through the second cooling loop, a condenser for rejecting heat from the second cooling fluid, an economizer pump for selectively pumping the second cooling fluid through the second cooling loop, or any combination thereof.

In at least one embodiment, the controller can monitor various sensors and/or control various components of the system. In at least one embodiment, the controller can monitor the exit temperature, the supply temperature, one or more ambient conditions, such as one or more other temperatures, one or more pressures, one or more temperatures and/or pressures associated with the condenser and/or the compressor, such as a condensing pressure, a condensing temperature, a suction pressure of the compressor, an outlet pressure of the compressor, a differential pressure across the compressor, one or more other conditions, or any combination thereof. In at least one embodiment, the controller can control the diverter valve, the compressor, the pump, an expansion valve, one or more other valves and/or one or more fans of the system, other components associated with the system, or any combination thereof.

In at least one embodiment, the controller can ensure and/or seek to ensure that the first cooling fluid enters the load at or reasonably near the supply temperature setpoint, the compressor operates within its operating parameters when it is needed to cool the first cooling fluid, shut down the compressor and run the economizer pump when the compressor is not needed to cool the first cooling fluid, or any combination thereof. In at least one embodiment, the controller can selectively heat the first cooling fluid from the exit temperature to a supply temperature setpoint, such that the first cooling fluid enters the load at the supply temperature setpoint, when the exit temperature is below the supply temperature setpoint. In at least one embodiment, the controller can selectively heat the first cooling fluid by operation of the diverter valve, diverting a portion of the first cooling fluid to the blending point and bypassing the heat exchanger. In at least one embodiment, the controller can determine an opening position for the diverter valve, based at least in part on the exit temperature, the supply temperature, an operating condition of the compressor, an ambient condition, such as an ambient temperature, one or more other temperatures and/or pressures, or any combination thereof, such as for selectively heating the first cooling fluid from the exit temperature to the supply temperature setpoint.

In at least one embodiment, the controller can control the exit temperature of the first cooling fluid exiting the heat exchanger, such as by controlling operation of the economizer pump, the compressor, one or more other components of the system, or any combination thereof. In at least one embodiment, the controller can cool the first cooling fluid exiting the heat exchanger, such as when a condition is below a threshold and/or the compressor is running. In at least one embodiment, the controller can cool the first cooling fluid exiting the heat exchanger below the supply temperature setpoint and simultaneously heat the first cooling fluid from the exit temperature to the supply temperature setpoint before entering the load, such as to ensure the first cooling fluid enters the load at the supply temperature setpoint and the compressor is operating within parameters. In at least one embodiment, the controller can prevent any portion of the first cooling fluid from bypassing the heat exchanger utilizing the diverter valve, such as when the compressor is not running, when the economizer pump is running, when cooling the first cooling fluid is near the supply temperature setpoint, or any combination thereof.

In at least one embodiment, the controller can monitor one or more conditions associated with the second loop, such as one or more temperatures, one or more pressures, one or more differential pressures, or any combination thereof. In at least one embodiment, the controller can cause the compressor to cool the first cooling fluid exiting the heat exchanger below the supply temperature setpoint, such as when the compressor is running and/or when the condition is below a threshold. In at least one embodiment, the controller can selectively cause the compressor to cool the first cooling fluid exiting the heat exchanger below the supply temperature setpoint and simultaneously control the diverter valve to heat the first cooling fluid from the exit temperature to the supply temperature setpoint before entering the load.

In at least one embodiment, the controller can monitor a differential pressure across the compressor. In at least one embodiment, the controller can ensure the differential pressure stays within the operating parameters of the compressor and the first cooling fluid enters the load at the supply temperature setpoint. In at least one embodiment, the controller can maintain the differential pressure above a threshold by cooling the first cooling fluid exiting the heat exchanger below the supply temperature setpoint. In at least one embodiment, the controller can control the diverter valve to divert at least a portion of the first cooling fluid to the blending point, bypassing the heat exchanger, to heat the first cooling fluid to the supply temperature setpoint before entering the load. in at least one embodiment, the controller can maintain the differential pressure above a threshold by causing the compressor to cool the first cooling fluid exiting the heat exchanger below the supply temperature setpoint and simultaneously control the diverter valve to heat the first cooling fluid from the exit temperature to the supply temperature setpoint before entering the load.

Other and further embodiments utilizing one or more aspects of the disclosure can be devised without departing from the spirit of Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope or range of equivalents of the following claims.
The disclosure comprises the following items:
1. A cooling system comprising:
   a first cooling loop including:
      a heat exchanger configured to extract heat from a first cooling fluid;
      a first sensor configured to sense an exit temperature of the first cooling fluid exiting the heat exchanger;
      a second sensor configured to sense a supply temperature of the first cooling fluid entering a load downstream of the heat exchanger; and
      a valve configured to selectively divert a portion of the first cooling fluid from upstream of the heat exchanger to a blending point in the first cooling loop between the first sensor and the second sensor, bypassing the heat exchanger; and
   a controller configured to:
      monitor the exit temperature and the supply temperature; and control the valve;
   wherein the cooling system is configured to selectively heat the first cooling fluid from the exit temperature to a supply temperature setpoint when the exit temperature is below the supply temperature setpoint, and to supply the first cooling fluid to the load at the supply temperature setpoint.
2. The cooling system as set forth in item 1, wherein the controller is further configured to determine an opening position for the valve, based at least in part on the exit temperature and the supply temperature, for selectively heating the first cooling fluid from the exit temperature to the supply temperature setpoint.
3. The cooling system as set forth in any preceding item, wherein the controller is further configured to monitor an ambient condition.
4. The cooling system as set forth in any preceding item, wherein the controller is further configured to control the exit temperature of the first cooling fluid exiting the heat exchanger.
5. The cooling system as set forth in any preceding item, wherein the controller is further configured to cool the first cooling fluid exiting the heat exchanger when the ambient condition is below a threshold.
6. The cooling system as set forth in any preceding item, wherein the controller is further configured to cool the first cooling fluid exiting the heat exchanger when a compressor is running and the ambient condition is below a threshold.
7. The cooling system as set forth in any preceding item, wherein the controller is further configured to cool the first cooling fluid exiting the heat exchanger below the supply temperature setpoint and simultaneously heat the first cooling fluid from the exit temperature to the supply temperature setpoint before entering the load.
8. The cooling system as set forth in any preceding item, wherein the controller is further configured to, when a compressor is not running, control the valve to prevent any portion of the first cooling fluid from bypassing the heat exchanger.
9. The cooling system as set forth in any preceding item, further comprising a second cooling loop having a second cooling fluid circulating therein and wherein the heat exchanger is further configured to transfer heat from the first cooling fluid to the second cooling fluid.
10. The cooling system as set forth in any preceding item, wherein the second cooling loop comprises:
   a compressor configured to selectively compress an evaporated portion of the second cooling fluid and induce the second cooling fluid to flow through the second cooling loop; and
   a condenser configured to reject heat from the second cooling fluid.
11. The cooling system as set forth in any preceding item, wherein the controller is further configured to monitor at least one condition associated with the second loop; and wherein the at least one condition is selected from the group consisting of a temperature, a pressure, a differential pressure, or a combination thereof.
12. The cooling system as set forth in any preceding item, wherein the controller is further configured to, when the condition is below a threshold, cause the compressor to cool the first cooling fluid exiting the heat exchanger to below the supply temperature setpoint.
13. The cooling system as set forth in any preceding item, wherein the controller is further configured to, when the compressor is running and the condition is below a threshold, cool the first cooling fluid exiting the heat exchanger to below the supply temperature setpoint.
14. The cooling system as set forth in any preceding item, wherein the controller is further configured to selectively cause the compressor to cool the first cooling fluid exiting the heat exchanger to below the supply temperature setpoint and simultaneously control the valve to heat the first cooling fluid from the exit temperature to the supply temperature setpoint before entering the load.
15. The cooling system as set forth in any preceding item, wherein the controller is further configured to monitor a differential pressure across the compressor.
16. The cooling system as set forth in any preceding item, wherein the controller is further configured to maintain the differential pressure above a threshold by cooling the first cooling fluid exiting the heat exchanger to below the supply temperature setpoint.
17. The cooling system as set forth in any preceding item, wherein the controller is further configured to control the valve to divert at least a portion of the first cooling fluid to the blending point, bypassing the heat exchanger, to heat the first cooling fluid to the supply temperature setpoint before entering the load.
18. The cooling system as set forth in any preceding item, wherein the controller is further configured to maintain the differential pressure above a threshold by causing the compressor to cool the first cooling fluid exiting the heat exchanger below the supply temperature setpoint and simultaneously control the valve to heat the first cooling fluid from the exit temperature to the supply temperature setpoint before entering the load.
19. The cooling system as set forth in any preceding item, wherein the second cooling loop further comprises a pump configured to selectively pump the second cooling fluid through the second cooling loop.
20. The cooling system as set forth in any preceding item, wherein the controller is further configured to control the valve to prevent any portion of the first cooling fluid from bypassing the heat exchanger when the pump is running.

## Claims

1. A cooling system comprising:
a first cooling loop including:
a heat exchanger configured to extract heat from a first cooling fluid;
a first sensor configured to sense an exit temperature of the first cooling fluid exiting the heat exchanger;
a second sensor configured to sense a supply temperature of the first cooling fluid entering a load downstream of the heat exchanger; and
a valve configured to selectively divert a portion of the first cooling fluid from upstream of the heat exchanger to a blending point in the first cooling loop between the first sensor and the second sensor, bypassing the heat exchanger; and
a controller configured to:
monitor the exit temperature and the supply temperature; and
control the valve;
wherein the cooling system is configured to selectively heat the first cooling fluid from the exit temperature to a supply temperature setpoint when the exit temperature is below the supply temperature setpoint, and to supply the first cooling fluid to the load at the supply temperature setpoint.

2. The cooling system as set forth in claim 1, wherein the controller is further configured to determine an opening position for the valve, based at least in part on the exit temperature and the supply temperature, for selectively heating the first cooling fluid from the exit temperature to the supply temperature setpoint.

3. The cooling system as set forth in any preceding claim, wherein the controller is further configured to monitor an ambient condition.

4. The cooling system as set forth in any preceding claim, wherein the controller is further configured to control the exit temperature of the first cooling fluid exiting the heat exchanger.

5. The cooling system as set forth in claim 3, wherein the controller is further configured to cool the first cooling fluid exiting the heat exchanger when the ambient condition is below a threshold, and/or wherein the controller is further configured to cool the first cooling fluid exiting the heat exchanger when a compressor is running and the ambient condition is below a threshold.

6. The cooling system as set forth in any preceding claim, wherein the controller is further configured to cool the first cooling fluid exiting the heat exchanger below the supply temperature setpoint and simultaneously heat the first cooling fluid from the exit temperature to the supply temperature setpoint before entering the load.

7. The cooling system as set forth in any preceding claim, wherein the controller is further configured to, when a compressor is not running, control the valve to prevent any portion of the first cooling fluid from bypassing the heat exchanger.

8. The cooling system as set forth in any preceding claim, further comprising a second cooling loop having a second cooling fluid circulating therein and wherein the heat exchanger is further configured to transfer heat from the first cooling fluid to the second cooling fluid, wherein the second cooling loop comprises:
a compressor configured to selectively compress an evaporated portion of the second cooling fluid and induce the second cooling fluid to flow through the second cooling loop; and
a condenser configured to reject heat from the second cooling fluid.

9. The cooling system as set forth in claim 8, wherein the controller is further configured to monitor at least one condition associated with the second loop; and wherein the at least one condition is selected from the group consisting of a temperature, a pressure, a differential pressure, or a combination thereof.

10. The cooling system as set forth in claim 9, wherein the controller is further configured to, when the condition is below a threshold, cause the compressor to cool the first cooling fluid exiting the heat exchanger to below the supply temperature setpoint, or wherein the controller is further configured to, when the compressor is running and the condition is below a threshold, cool the first cooling fluid exiting the heat exchanger to below the supply temperature setpoint.

11. The cooling system as set forth in any of claims 8-10, wherein the controller is further configured to selectively cause the compressor to cool the first cooling fluid exiting the heat exchanger to below the supply temperature setpoint and simultaneously control the valve to heat the first cooling fluid from the exit temperature to the supply temperature setpoint before entering the load.

12. The cooling system as set forth in any of claims 8-11, wherein the controller is further configured to monitor a differential pressure across the compressor.

13. The cooling system as set forth in claim 12, wherein the controller is further configured to maintain the differential pressure above a threshold by cooling the first cooling fluid exiting the heat exchanger to below the supply temperature setpoint, and/or wherein the controller is further configured to maintain the differential pressure above a threshold by causing the compressor to cool the first cooling fluid exiting the heat exchanger below the supply temperature setpoint and simultaneously control the valve to heat the first cooling fluid from the exit temperature to the supply temperature setpoint before entering the load.

14. The cooling system as set forth in any preceding claim, wherein the controller is further configured to control the valve to divert at least a portion of the first cooling fluid to the blending point, bypassing the heat exchanger, to heat the first cooling fluid to the supply temperature setpoint before entering the load.

15. The cooling system as set forth in any of claims 8-14, wherein the second cooling loop further comprises a pump configured to selectively pump the second cooling fluid through the second cooling loop, and optionally wherein the controller is further configured to control the valve to prevent any portion of the first cooling fluid from bypassing the heat exchanger when the pump is running.
